# EUROPEAN PATENT SPECIFICATION

(11) **EP 3 387 840 B1**
(45) Date of publication and mention of the grant of the patent: **06.12.2023**
(21) Application number: 16852873.5
(22) Date of filing: 31.10.2016
(51) Int. Cl.: H04R 1/10, H03G 3/32, G06F 3/01, G06F 3/03, G01H 3/04

(54) **APPARATUS FOR CONTROLLING EARPHONE OR MEDIA PLAYER IN COMMUNICATION WITH THE EARPHONE, AND CONTROLLING METHOD THEREOF**
VORRICHTUNG ZUR STEUERUNG EINES KOPFHÖRERS ODER MIT DEM KOPFHÖRER KOMMUNIZIERENDEN MEDIENSPIELERS UND STEUERUNGSVERFAHREN DAFÜR
APPAREIL DE COMMANDE D'ÉCOUTEUR OU DE LECTEUR MULTIMÉDIA EN COMMUNICATION AVEC L'ÉCOUTEUR, ET PROCÉDÉ DE COMMANDE ASSOCIÉ

(30) Priority: 07.12.2015 CN 201510892219
(43) Date of publication of application: 17.10.2018
(73) Proprietor: BOE Technology Group Co., Ltd., Beijing 100015 (CN)
(72) Inventor: YANG, Jiuxia, Beijing 100176 (CN)
(74) Representative: Cohausz & Florack
(86) International application number: PCT/CN2016/103960
(87) International publication number: WO 2017/097058

(56) References cited:
- EP-A1- 2 388 787
- EP-A2- 0 298 046
- CN-A- 101 552 595
- CN-A- 104 506 586
- CN-A- 104 685 908
- CN-A- 105 472 497
- US-A1- 2009 022 329
- US-A1- 2012 070 014
- US-A1- 2013 064 380
- US-A1- 2015 171 813

## Description

### TECHNICAL FIELD

The present invention relates to an apparatus for controlling an earphone or a media player in communication with the earphone.

### BACKGROUND

Wearable apparatuses such as earphones have been widely used. An earphone is typically connected to a media player through a cord or a Bluetooth connection. Typically, a user may change a volume produced by the earphone speaker and contents broadcasted by the media player only by controlling a keypad on the media player.

US patent application US2009/022329A1 discloses a system that uses a sound sensor to adjust the audio output of a device. During operation, the system uses the sound sensor to determine an ambient sound level for the environment in the proximity of the device. The system then adjusts a volume setting for the device adaptively based on the determined ambient sound level. Adaptively adjusting the volume setting allows the device to adapt to its audio environment and ameliorates potentially-disruptive audio outputs.

EP patent application EP0298046A2 discloses a device for measuring, indicating and controlling ambient sound pressure levels comprises a probe (8) connected to a sound level meter (2), the output signal from which is proportional to sound pressure picked up by the probe; the signal from the meter is compared with a given threshold, and if found to be higher, causes a control signal to be generated that triggers the operation of indicator lights or alarms (6), and/or of a limiter (4) by which sound pressure in the environment is attenuated automatically. The device is intended for use in surroundings such as discotheques, building sites or factory premises etc., where sound pressure levels attributable to noise generated within the environment can prove a source of annoyance, or even of harm, to persons occupying the area.

CN patent application CN101552595A discloses an electronic product volume regulating method and a device thereof. The method comprises the following steps: the volume value of the external environment volume is obtained; the volume value of the environment volume is compared with a first preset threshold, so as to generate a first comparison result; when the first comparison result indicates that the volume value of the environment volume is smaller than the first preset threshold, a first volume regulating mode is used for regulating the volume; when the first comparison result indicates that the volume value of the environment volume is larger than the first preset threshold, a second volume regulating mode is used for regulating the volume; and the first volume regulating mode is different from the second volume regulating mode. According to the volume status of the external environment, three volume regulating modes such as a silent regulating mode, a normal regulating mode and a noisy regulating mode can be set. The method can ensure that the output volume has nonlinear variation according to the volume of the surrounding environment.

EP patent application EP2388787A1 discloses a gesture based headphone for controlling a media player device and method for using thereof. The headphone comprises a cord with a gesture sensitive region in the cord, and an interface for connecting to the media player device. A user gesture interacts with the gesture sensitive region and generates a control input for controlling the media player device, wherein the user gesture includes at least one gesture generating a control input.

### SUMMARY

In one aspect, the present invention provides an apparatus for controlling an earphone and a media player in communication with the earphone, comprising an ambient sound detector configured to detect an ambient sound volume level; a processor configured to select an adjustment value to be applied to an audio volume level to be produced by an earphone speaker of the earphone based on the ambient sound volume level; and a controller configured to adjust the audio volume level of the earphone speaker based on the adjustment value selected by the processor; wherein the processor is configured to generate a first prompt signal when the ambient sound detector detects an ambient sound volume level higher than a threshold level; and the controller is configured to receive and output the first prompt signal, wherein the processor is configured to generate a second prompt signal when the ambient sound detector detects an ambient sound volume level higher than the threshold level upon lapse of a first time interval after the first prompt signal is generated; and the controller is configured to output the second prompt signal at least once upon receiving the second prompt signal, and discontinue output of system sound from the earphone speaker after the second prompt signal is outputted for N times, N is an integer greater than 1.

Optionally, the ambient sound detector comprises a first sensor connected to a first analyzer; the first sensor is configured to convert the ambient sound volume level to a first signal; the first signal being one of a voltage signal, a current signal, and a pressure signal; and the first analyzer is configured to receive and analyze the first signal to generate a second signal representing the ambient sound volume level.

Optionally, the first sensor is a sound sensor comprising an electret condenser microphone, or the first sensor is a pressure sensor.

Optionally, a first adjustment value is selected and applied to the audio volume level when the ambient sound volume level is in a first ambient sound volume range, and a second adjustment value is selected and applied to the audio volume level when the ambient sound volume level is in a second ambient sound volume range; a minimum ambient sound volume level in the second ambient sound volume range is higher than a maximum ambient sound volume level in the first ambient sound volume range; and the second adjustment value is higher than the first adjustment value.

Optionally, the processor is configured to generate the first prompt signal when the ambient sound volume level is higher than a maximum ambient sound volume level in the second ambient sound volume range; and the controller is configured to receive and output the first prompt signal.

Optionally, the ambient sound detector is configured to detect the ambient sound volume level upon lapse of the first time interval after the first prompt signal is generated; the processor is configured to select the adjustment value to be applied to the audio volume level to be produced by an earphone speaker based on the ambient sound volume level; and the controller is configured to adjust the audio volume level of the earphone speaker based on the adjustment value selected by the processor.

Optionally, the controller is configured to resume output of system sound from the earphone speaker upon lapse of a second time interval after output of system sound is discontinued.

Optionally, the apparatus further comprises a gesture detector configured to detect a user gesture; wherein the processor is configured to select a control instruction for controlling a media player in communication with the earphone based on the user gesture; and the controller is configured to transmit the control instruction to the media player.

In another aspect, the present invention provides an earphone comprising an apparatus as defined in claims 1 to 8.

Optionally, the earphone is one of a moving coil earphone and a bone conduction earphone.

In another aspect, the present invention provides a wearable apparatus comprising an apparatus as defined in claims 1 to 8.

### BRIEF DESCRIPTION OF THE FIGURES

The following drawings are merely examples for illustrative purposes according to various disclosed embodiments and are not intended to limit the scope of the present invention.
FIG. 1 is a diagram illustrating the structure of an apparatus for controlling an earphone in some embodiments according to the present disclosure.
FIG. 2 is a diagram illustrating the structure of an apparatus for controlling an earphone in some embodiments according to the present disclosure.
FIG. 3 is a diagram illustrating the structure of an apparatus for controlling an earphone and a media player in communication with the earphone in some embodiments according to the present disclosure.
FIG. 4 is a flow chart illustrating a method for controlling an earphone and a media player in communication with the earphone in some embodiments according to an disclosed embodiment which is not according to the invention and is present for illustration purposes only.

### DETAILED DESCRIPTION

The disclosure will now be described more specifically with reference to the following embodiments. It is to be noted that the following descriptions of some embodiments are presented herein for purpose of illustration and description only. It is not intended to be exhaustive or to be limited to the precise form disclosed.

In conventional media player systems having an earphone, the audio volume level produced by the earphone speaker may be adjusted by a manual operation. Similarly, a user may control the contents broadcasted by the media player manually through an input device, e.g., a key pad on a smart phone. The conventional design is not user friendly in many environments when a user is multi-tasking. For example, it is difficult for a user to change the contents broadcasted by the media player when the user is driving. It is also inconvenient for a user to adjust earphone volume to compensate ambient noise increase when the user is jogging on a treadmill.

Accordingly, the present invention provides, *inter alia*, an apparatus for controlling an earphone or a media player in communication with the earphone that substantially obviate one or more of the problems due to limitations and disadvantages of the related art. In one aspect, the present disclosure provides an apparatus for controlling an earphone or a media player in communication with the earphone. In some embodiments, the apparatus includes an ambient sound detector configured to detect an ambient sound volume level; a processor configured to select an adjustment value to be applied to an audio volume level to be produced by an earphone speaker of the earphone based on the ambient sound volume level; and a controller configured to adjust the audio volume level of the earphone speaker based on the adjustment value selected by the processor. The processor is configured to generate a first prompt signal when the ambient sound detector detects an ambient sound volume level higher than a threshold level; and the controller is configured to receive and output the first prompt signal. The processor is configured to generate a second prompt signal when the ambient sound detector detects an ambient sound volume level higher than the threshold level upon lapse of a first time interval after the first prompt signal is generated; and the controller is configured to output the second prompt signal at least once upon receiving the second prompt signal, and discontinue output of system sound from the earphone speaker after the second prompt signal is outputted for N times, N is an integer greater than 1.

In some embodiments, the apparatus includes a gesture detector configured to detect a user gesture; a processor configured to select a control instruction for controlling a media player in communication with the earphone based on the user gesture; and a controller configured to transmit the control instruction to the media player.

In some embodiments, the apparatus includes an ambient sound detector configured to detect an ambient sound volume level; a gesture detector configured to detect a user gesture; a processor configured to select an adjustment value to be applied to an audio volume level to be produced by an earphone speaker of the earphone based on the ambient sound volume level, and select a control instruction for controlling a media player in communication with the earphone based on the user gesture; and a controller configured to adjust the audio volume level of the earphone speaker based on the adjustment value selected by the processor, and transmit the control instruction to the media player. Optionally, the sensors of the ambient sound detector and the gesture detector are integrated as a dual-sensor.

As used herein, the term "earphone" encompasses any type of device that projects sound into a listener's ear(s). For example, this may include earbuds that fit directly into the ear canal, devices that wrap around the listener's ear lobes and minimally infiltrate the ear canal, and devices that merely cover the ear. As used herein, the term "audio volume" encompasses audio volume of any system sound broadcasted by a media player and produced by an earphone in communication with the media player. The system sound broadcasted by the media player may be a sound from a sound track, an internet radio, a telephone call conversation, a ring tone, and the like.

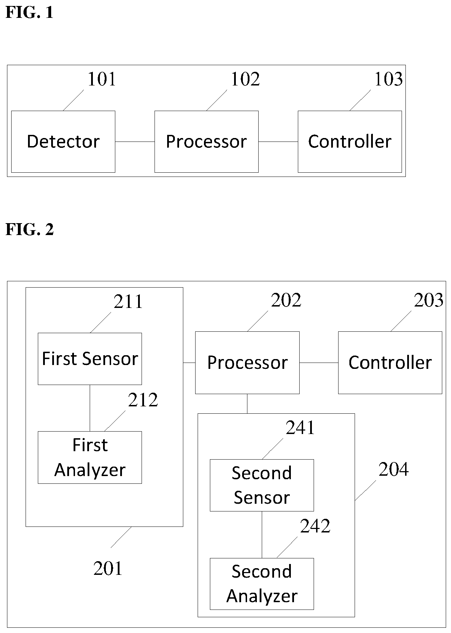

FIG. 1 is a diagram illustrating the structure of an apparatus for controlling an earphone in some embodiments according to the present disclosure. Referring to FIG. 1, the apparatus in some embodiments includes a detector 101, a processor 102, and a controller 103. The detector 101 may be an ambient sound detector for detecting an ambient sound volume level. Optionally, the detector 101 includes a gesture detector for detecting a user gesture. Optionally, the detector 101 includes both an ambient sound detector and a gesture detector. The processor 102 is configured to select an adjustment value to be applied to an audio volume level to be produced by an earphone speaker of the earphone based on the ambient sound volume level. The controller 103 is configured to adjust the audio volume level of the earphone speaker based on the adjustment value selected by the processor.

The present apparatus can automatically adjust the audio volume level of the earphone speaker according to ambient noise level, obviating the need of manual volume adjustment by a user. For example, when a user is listening to a sound track while exercising on a treadmill in a crowded gym, the present apparatus is capable of automatically adjusting the audio volume level of the earphone speaker to compensate the ambient noise. When someone turns on a television in the gym, the ambient noise level goes up. By having the present apparatus implemented in combination with the earphone or a media player in communication with the earphone, the earphone speaker volume can be automatically adjusted to a higher level. The user needs not stop the treadmill and adjust the audio volume manually.

The audio volume level of the earphone speaker may be adjusted using various appropriate methods. In some embodiments, the apparatus automatically controls the volume level of the earphone directly, without changing the audio volume level setting in the media player in communication with the earphone. In some embodiments, the apparatus automatically controls the volume level of the earphone by changing the audio volume level setting in the media player in communication with the earphone. In some embodiments, the apparatus automatically controls the volume level of the earphone by changing the audio volume level settings in both the earphone and the media player in communication with the earphone.

In some embodiments, the apparatus is integrated into an earphone. In some embodiments, the apparatus is integrated into a wearable device in communication with an earphone. In some embodiments, the apparatus is integrated into a wearable device having the earphone. For example, the wearable device may include at least an earphone bud connected to a portion configured to be worn around a neck of a user, and the present apparatus may be integrated into the portion worn around the neck. In some embodiments, the apparatus is a stand-alone apparatus in communication with the earphone and the media player. In some embodiments, the apparatus may be integrated into a remote control of the media player.

In some embodiments, the detector is an ambient sound detector. FIG. 2 is a diagram illustrating the structure of an apparatus for controlling an earphone in some embodiments according to the present disclosure. Referring to FIG. 2, the apparatus in some embodiments includes an ambient sound detector 201 configured to detect an ambient sound volume level, a processor 202 configured to select an adjustment value to be applied to an audio volume level to be produced by an earphone speaker of the earphone based on the ambient sound volume level, and a controller 203 configured to adjust the audio volume level of the earphone speaker based on the adjustment value selected by the processor. The ambient sound detector 201 includes a first sensor 211 connected to a first analyzer 212. The first sensor 211 is configured to convert the ambient sound volume level to a first signal. The first signal may be a signal of any appropriate form, depending on the type of sensor used in detecting ambient sound. Examples of appropriate first signals include, but are not limited to, a voltage signal, a current signal, a pressure signal, or a combination thereof. The first analyzer 212 is configured to receive and analyze the first signal to generate a second signal representing the ambient sound volume level. Optionally, the first analyzer 212 includes an analog-to-digital converter converting the first signal into the second signal. Optionally, the first sensor includes an analog-to-digital converter converting the first signal into a digital signal, which is then received and analyzed by the first analyzer 212 to generate a second signal representing the ambient sound volume level.

In some embodiments, the first sensor is a sound sensor. Examples of sound sensors include various microphones, e.g., an electret condenser microphone. In an electret condenser microphone, a sound wave received by the microphone causes vibration of an electret film in the microphone, leading to a capacitance change. A voltage signal or a current signal is generated upon the capacitance change. The first analyzer receives and analyze the voltage signal or the current signal, and generates a second signal representing the ambient sound volume level.

In some embodiments, the first sensor is a pressure sensor. The pressure sensor receives a sound wave and generates a pressure signal. Based on the pressure signal, the first analyzer generates a second signal representing the ambient sound volume level.

Optionally, the first analyzer 212 may include any logic, logic device, circuit, application specific integrated circuit (ASIC), chip, processor, controller, or any combination thereof, capable of executing a series of commands, instructions or state transitions.

Optionally, the processor 202 may include any logic, logic device, circuit, application specific integrated circuit (ASIC), chip, processor, controller, or any combination thereof, capable of executing a series of commands, instructions or state transitions.

Optionally, the controller 203 may include any logic, logic device, circuit, application specific integrated circuit (ASIC), chip, processor, controller, or any combination thereof, capable of executing a series of commands, instructions or state transitions. Optionally, the controller 203 is an audio volume adjustment circuit configured to adjust audio volume by varying the outputted current. Optionally, the controller 203 is integrated into the earphone. Optionally, the controller 203 is integrated into a media player in communication with the earphone.

In some embodiments, the processor is configured to select the adjustment value to be applied to an audio volume level to be produced by an earphone speaker of the earphone based on the ambient sound volume level detected by the ambient sound detector, and a look-up table having a plurality of correlations between a plurality of adjustment values and a plurality of corresponding ambient noise levels. The adjustment value is selected based on its correlation to the ambient noise level. Optionally, the apparatus further includes a memory storing the correlations between the adjustment values and the ambient noise levels. Each ambient noise level corresponds to an adjustment value, which in turn corresponds to an audio volume level. For example, the audio volume level may be expressed in a scale of 1 to 100, and the adjustment value may be a value of 10 to be added to the audio volume level in response to an increase in ambient noise level. In one example, the adjustment value may be a value of 10 to be subtracted from the audio volume level in response to a decrease in ambient noise level. In one example, the audio volume level may be visualized as a volume slider. The effect of a positive adjustment value is equivalent to an adjustment operated on the volume slider for increasing the audio volume, and the effect of a negative adjustment value is equivalent to an adjustment operated on the volume slider for decreasing the audio volume. Optionally, the adjustment value is a multiplication factor to be applied to the audio volume level. In one example, an adjustment value to increase the audio volume level may be a multiplication factor of 1.1 applied to the existing audio volume level. In another example, an adjustment value to decrease the audio volume level may be a multiplication factor of 0.9 applied to the existing audio volume level. Optionally, the look-up table includes a plurality of ambient sound volume ranges and a plurality of corresponding adjustment values, each of the ambient sound volume range corresponding to one of the plurality of adjustment values. When a certain ambient sound volume level is detected, the ambient sound volume range including the detected ambient sound volume level can be determined, and the corresponding adjustment value can be conveniently selected using the look-up table. Optionally, the plurality of ambient sound volume ranges are mutually exclusive.

In some embodiments, the loop-up table may be automatically updated by user inputs. For example, the processor is configured to automatically select an adjustment value to be applied to an audio volume level based on the ambient sound volume level detected, and an existing look-up table including a plurality of existing correlations between a plurality of adjustment values and a plurality of corresponding ambient noise levels; and the controller is configured to adjust the audio volume level of the earphone speaker based on the adjustment value. If the user feels comfortable with the automatically adjusted audio volume level, the user may continue listening to the sound track broadcasted in the earphone. In some embodiments, the apparatus allows a user to manually adjust the audio volume level to a different level for better user experience. The processor is configured to automatically update the loop-up table using an updated adjustment value corresponding to the audio volume level selected by the user. By having the design, the control of the earphone may be personalized, and the adjustment can be tailored to each individual. Accordingly, in some embodiments, the processor is configured to receive a user input providing an updated audio volume level, calculate an updated adjustment value corresponding to the ambient sound volume level based on the updated audio volume level provided by the user input, and update the plurality of existing correlations between a plurality of adjustment values and a plurality of corresponding ambient noise levels with the updated adjustment value.

In some embodiments, the loop-up table may be automatically updated by user inputs inputted by a user gesture. For example, the processor is configured to automatically select an adjustment value to be applied to an audio volume level based on the ambient sound volume level detected, and an existing look-up table including a plurality of existing correlations between a plurality of adjustment values and a plurality of corresponding ambient noise levels; and the controller is configured to adjust the audio volume level of the earphone speaker based on the adjustment value. The user can adjust the audio volume level to a different level using a user gesture. The user gestures include a first user gesture for increasing the audio volume level and a second user gesture for decreasing the audio volume level. The processor is configured to automatically update the loop-up table using an updated adjustment value corresponding to the audio volume level adjusted by the user. Accordingly, in some embodiments, the detector is configured to detect a user gesture providing an updated audio volume level, the processor is configured to calculate an updated adjustment value corresponding to the ambient sound volume level based on the updated audio volume level provided by the user gesture, and update the plurality of existing correlations between a plurality of adjustment values and a plurality of corresponding ambient noise levels with the updated adjustment value.

In some embodiments, the user experience may be further enhanced by separately controlling each individual earphone speaker (e.g., a left earbud and a right earbud). Accordingly, in some embodiments, the ambient sound detector is configured to detect an ambient sound volume level; the processor is configured to select a first adjustment value to be applied to an audio volume level to be produced by a first earphone speaker of the earphone based on the ambient sound volume level; the processor is configured to select a second adjustment value to be applied to an audio volume level to be produced by a second earphone speaker of the earphone based on the ambient sound volume level; the controller is configured to adjust the audio volume level of the first earphone speaker based on the first adjustment value; and adjusting the audio volume level of the second earphone speaker based on the second adjustment value. In some embodiments, the processor is configured to select the first adjustment value based on the ambient sound volume level detected, and a plurality of first existing correlations between a plurality of adjustment values and a plurality of corresponding ambient noise levels; and the processor is configured to select the second adjustment value based on the ambient sound volume level detected, and a plurality of second existing correlations between a plurality of adjustment values and a plurality of corresponding ambient noise levels. In some embodiments, the processor is configured to receive a first user input providing a first updated audio volume level to be produced by the first earphone speaker, calculate a first updated adjustment value corresponding to the ambient sound volume level, and update the plurality of first existing correlations with the first updated adjustment value. In some embodiments, the processor is configured to receive a second user input providing a second updated audio volume level to be produced by the second earphone speaker, calculate a second updated adjustment value corresponding to the ambient sound volume level, and update the plurality of second existing correlations with the second updated adjustment value.

Optionally, a first adjustment value is selected and applied to the audio volume level when the ambient sound volume level is in a first ambient sound volume range, and a second adjustment value is selected and applied to the audio volume level when the ambient sound volume level is in a second ambient sound volume range. A minimum ambient sound volume level in the second ambient sound volume range is higher than a maximum ambient sound volume level in the first ambient sound volume range, and the second adjustment value is higher than the first adjustment value. Optionally, the look-up table includes the first adjustment value, the second adjustment value, and at least a third adjustment value. Optionally, the look-up table includes the first ambient sound volume range, the second ambient sound volume range, and at least a third ambient sound volume range.

In some embodiments, the ambient sound volume level is determined as a cumulative ambient sound level, for example, ambient sound levels cumulated during a time interval (e.g., 5 seconds, 10 seconds). The ambient sound volume range is a range of cumulative ambient sound levels during a same time interval. Depending on the user needs, an appropriate time interval may be selected. In one example, a fast response is desired, accordingly a relatively short time interval may be selected for detecting the cumulative ambient sound level. In another example, frequent, brief fluctuations in ambient noise are expected, accordingly a relatively longer time interval may be selected to avoid unnecessary, frequent, adjustments on earphone speaker volume levels.

In some embodiments, the ambient sound volume level is determined as an average ambient sound level over a time period (e.g., 5 seconds, 10 seconds). The ambient sound volume range is a range of average ambient sound levels over a same time period. Depending on the user needs, an appropriate time period may be selected. In one example, a fast response is desired, accordingly a relatively short time period may be selected for detecting the average ambient sound level. In another example, frequent, brief fluctuations in ambient noise are expected, accordingly a relatively longer time period may be selected to avoid unnecessary, frequent, adjustments on earphone speaker volume levels.

Optionally, the correlation between the plurality of adjustment values and the plurality of ambient sound volume ranges is substantially a linear correlation. Optionally, the plurality of audio volume levels adjusted by the plurality of adjustment values and the plurality of ambient sound volume ranges is substantially a linear correlation. The louder the ambient noise, the louder the audio volume produced by the earphone speaker.

In some embodiment, the processor is configured to generate and apply an additional adjustment value in lieu of or in addition to the adjustment value applied to the audio volume level. In some examples, the additional adjustment value is an adjustment value for noise cancellation, noise reduction, or noise decreasing. In another example, the processor calculates a reversed version of the ambient noise, and apply it to cancel out the noise.

In some embodiment, the apparatus is configured to generate a prompt signal (e.g., an alarm) when the ambient sound volume level is higher than a threshold value. In one example, the processor is configured to generate a first prompt signal when the ambient sound volume level is higher than a maximum ambient sound volume level in the second ambient sound volume range, and the controller is configured to receive and output the first prompt signal. The prompt signal reminds the user that the ambient noise is at a level not suitable for listening to a sound track using an earphone. Upon receiving the prompt signal, the user may choose to discontinue the media player, or choose to leave the noisy environment. The prompt signal may be a voice message or an alarm sound.

In some embodiments, the ambient sound detector is configured to monitor the ambient noise continuously. For example, the ambient sound detector may be configured to detect a cumulative ambient sound volume level upon lapse of a time interval, e.g., every 30 seconds. Optionally, the ambient sound detector is configured to detect the ambient sound volume level upon lapse of a first time interval (e.g., 30 seconds) after the first prompt signal is generated. The processor is configured to select the adjustment value to be applied to the audio volume level to be produced by an earphone speaker based on the ambient sound volume level, and the controller is configured to adjust the audio volume level of the earphone speaker based on the adjustment value selected by the processor. By repeating the ambient sound detection process, it can be determined whether the ambient sound volume level becomes lower than the threshold value after the first prompt signal is generated.

In some embodiments, it is determined that the ambient sound volume level upon lapse of the first time interval after the first prompt signal is generated is still higher than a maximum ambient sound volume level in the second ambient sound volume range. In some examples, the processor is configured to generate a second prompt signal, and the controller is configured to output the second prompt signal to the user. Optionally, the controller is configured to output the second prompt signal to the user at least once upon receiving the second prompt signal. Optionally, the controller is configured to discontinue output of system sound from the earphone speaker after the second prompt signal is outputted for N times, N is an integer greater than 1, e.g., N = 3. In one example, the second prompt signal is outputted for N times in a certain period of time (e.g., 5 minutes or 10 minutes) before the output of system sound is discontinued.

In some embodiments, the controller is configured to automatically resume output of system sound from the earphone speaker upon lapse of a second time interval after output of system sound is discontinued. Optionally, once the output of system sound is resumed, the apparatus is configured to repeat the ambient noise detection process and alarm process as described above.

In some embodiments, the detector includes a gesture detector configured to detect a user gesture. The processor is configured to select a control instruction for controlling a media player in communication with the earphone based on the user gesture, and the controller is configured to transmit the control instruction to the media player. The contents broadcasted by the media player may be controlled by the present apparatus.

In some embodiments, the gesture detector is integrated into an earphone. In some embodiments, the gesture detector is integrated into a wearable device in communication with an earphone. In some embodiments, the gesture detector is integrated into a wearable device having the earphone. For example, the wearable device may include at least an earphone bud connected to a portion configured to be worn around a neck of a user, and the gesture detector may be integrated into the portion worn around the neck, e.g., the back of the neck.

In some embodiments, the apparatus includes both an ambient sound detector and a gesture detector. In some examples, the apparatus can automatically adjust the audio volume level of the earphone speaker according to ambient noise level, and enable a user to control the contents broadcasted by the media player by a gesture. This design obviates the needs of manual volume adjustment by a user or making changes to the contents broadcasted by the media player using an input terminal, greatly enhancing user experience.

Referring to FIG. 2, the gesture detector 204 in some embodiments includes a second sensor 241, and a second analyzer 242 connected to the second sensor 241. The second sensor 241 is configured to detect an ultrasound signal or an optical signal. The second analyzer 242 is configured to receive and analyze the ultrasound signal or the optical signal to generate a third signal representing the user gesture based on a wavelength or a frequency of the ultrasound signal or an optical image of the optical signal. Based on the third signal, the processor is configured to select a control instruction for controlling a media player in communication with the earphone, and the controller is configured to transmit the control instruction to the media player.

In some embodiments, the second sensor 241 includes at least one of an ultrasound sensor and an optical sensor. Optionally, the ultrasound sensor includes a piezoelectric wafer. Optionally, the ultrasound sensor is a dual-function ultrasound sensor capable of emitting ultrasound and detecting ultrasound.

In some embodiments, the second analyzer 242 analyzes a wavelength or a frequency of the ultrasound signal to generate a third signal representing the user gesture based on Doppler effect shift. The second analyzer 242 transmits the third signal to the processor 202 for downstream operations. According to Doppler's effect, sound waves reflected by an approaching object will shift towards shorter wavelengths and higher frequencies (blue shift effect), whereas sound waves reflected by a leaving object will shift towards longer wavelengths and lower frequencies (red shift effect). The higher the approaching object or the leaving object, the more significant the Doppler's effect becomes. Accordingly, the moving direction and speed of the approaching object or the leaving object can be calculated based on the blue shift effect or the red shift effect. A user gesture can be recognized by analyzing the wavelength or the frequency of the ultrasound signal.

In some embodiments, the second analyzer 242 analyzes an optical signal to generate a third signal representing the user gesture based on an optical image of the optical signal. In one example, the optical image is a trajectory image of the optical signal, the second analyzer 242 generates a trajectory of a user's hand with respect to time, and generates a third signal representing the user gesture corresponding to the trajectory image. In another example, the optical image is a static image of the optical signal, the second analyzer 242 generates a third signal representing the user gesture corresponding to the static image.

In some embodiments, the second analyzer 242 includes a database and an inference engine. Optionally, the database is configured to store the wavelength or the frequency of the ultrasound signal and a correlation between the user gesture and the wavelength or the frequency of the ultrasound signal. Optionally, the database is configured to store a correlation between the user gesture and the optical image of the optical signal. Optionally, the database is configured to store the wavelength or the frequency of the ultrasound signal, a correlation between the user gesture and the wavelength or the frequency of the ultrasound signal, and a correlation between the user gesture and the optical image of the optical signal. Moreover, the database may be configured to store raw data (e.g., an ultrasound signal), an intermediate result, and a final result. The database may be searchable and editable.

Optionally, the inference engine is configured to perform an inference computation based on the wavelength or the frequency of the ultrasound signal and the correlation between the user gesture and the wavelength or the frequency of the ultrasound signal, to determine the user gesture corresponding to the ultrasound signal. Optionally, the inference engine is configured to perform an inference computation based on the optical signal and the correlation between the user gesture and the optical image of the optical signal, to determine the user gesture corresponding to the optical signal.

Optionally, the database and the inference engine may be used to process other data, e.g., ambient sound volume levels.

Optionally, the gesture detector 204 further includes a de-noising logic configured to receive the ultrasound signal, perform a de-noising process on the optical signal, and output an denoised signal to the second analyzer 242. Optionally, the gesture detector 204 further includes a de-noising logic configured to receive the optical signal, perform a de-noising process on the optical signal, and output an denoised signal to the second analyzer 242. The second analyzer is configured to receive and analyze the denoised signal to generate a third signal representing the user gesture. The processor is configured to select a control instruction for controlling a media player in communication with the earphone bases on the third signal, and the controller is configured to transmit the control instruction to the media player. Optionally, the third signal is a coded signal, e.g., a coded instruction. By having a de-noising process, a more accurate gesture recognition can be made possible.

Optionally, the first sensor 211 and a second sensor 241 constitute a dual-probe ultrasound sensor. Optionally, the first sensor 211 includes a probe for receiving and detecting ambient noise, the second sensor 241 includes a probe for emitting ultrasound.

In some embodiments, the processor is configured to select a control instruction for controlling a media player in communication with the earphone bases on the user gesture detected, and a look-up table having a plurality of correlations between a plurality of user gestures and a plurality of corresponding control instructions. Optionally, the apparatus further includes a memory storing the correlations between the user gestures and the corresponding control instructions. Each user gesture corresponds to a control instruction.

In some embodiments, the plurality of user gestures include at least one of a first user gesture including a translational motion with a substantially uniform speed; a second user gesture including a translational motion with acceleration; a third user gesture including an up-and-down motion; a fourth user gesture including a clockwise circular motion; a fifth user gesture including a counter-clockwise circular motion; a sixth user gesture including a forward motion; and a seventh user gesture including a backward motion. In some embodiments, the plurality of control instructions include at least one of a first control instruction including pausing the media player; a second control instruction including playing the media player; a third control instruction including changing sound tracks; a fourth control instruction including playing a next track; a fifth control instruction including playing a previous track; a sixth control instruction including playing tracks in a sequential play mode; a seventh control instruction including playing tracks in a shuffle play mode; an eighth control instruction including accepting an incoming phone call; and a ninth control instruction including terminating a phone call. Any of the plurality of control instructions may be paired with one of the plurality of user gestures in the look-up table.

In some embodiments, the second sensor 241 is an ultrasound sensor; and the plurality of user gestures include a first user gesture including a translational motion with a substantially uniform speed and a second user gesture including a translational motion with acceleration. Optionally, the plurality of control instructions include a first control instruction including pausing the media player; a second control instruction including playing the media player; and a third control instruction including changing sound tracks. In one example, the first user gesture corresponds to a user instruction to pause or play the media player. In another example, the second user gesture corresponds to a user instruction to change sound tracks.

In some embodiments, the second sensor 241 is an optical sensor; and the plurality of user gestures include a third user gesture including an up-and-down motion; a fourth user gesture including a clockwise circular motion; a fifth user gesture including a counter-clockwise circular motion; a sixth user gesture including a forward motion; and a seventh user gesture including a backward motion. Optionally, the plurality of control instructions include a fourth control instruction including playing a next track; a fifth control instruction including playing a previous track; a sixth control instruction including playing tracks in a sequential play mode; and a seventh control instruction including playing tracks in a shuffle play mode. In one example, the third user gesture corresponds to the fourth control instruction or the fifth control instruction. In another example, the fourth user gesture and the fifth user gesture correspond to the sixth control instruction and the seventh control instruction.

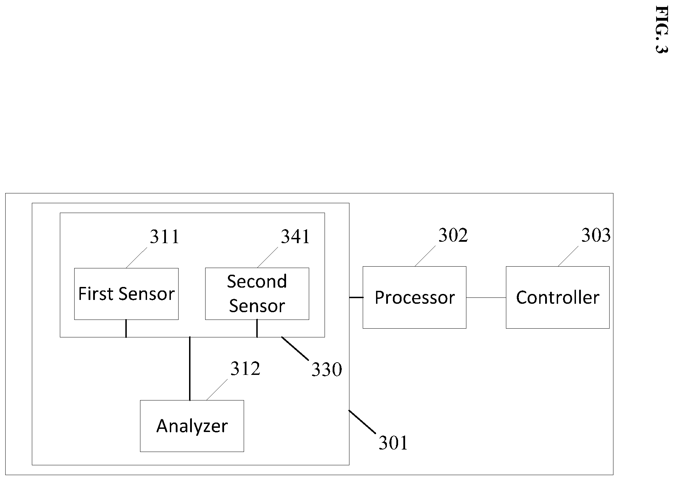

FIG. 3 is a diagram illustrating the structure of an apparatus for controlling an earphone and a media player in communication with the earphone in some embodiments according to the present disclosure. Referring to FIG. 3, the apparatus in some embodiments includes a detector 301 configured to detect an ambient sound volume level and a user gesture. The detector 301 includes a dual function sensor 330 connected to an analyzer 312. The dual function sensor 330 includes a first sensor 311 configured to convert the ambient sound volume level to a first signal, and a second sensor 341 configured to detect an ultrasound signal or an optical signal. The analyzer 312 is configured to receive and analyze the first signal to generate a second signal representing the ambient sound volume level, and configured to receive and analyze the ultrasound signal or the optical signal to generate a third signal representing the user gesture based on a wavelength or a frequency of the ultrasound signal or an optical image of the optical signal. The apparatus further includes a processor 302 and a controller 303. The processor 302 is configured to select an adjustment value to be applied to an audio volume level to be produced by an earphone speaker of the earphone based on the ambient sound volume level, and configured to select a control instruction for controlling a media player in communication with the earphone based on the third signal. The controller 303 is configured to adjust the audio volume level of the earphone speaker based on the adjustment value selected by the processor, and configured to transmit the control instruction to the media player. Optionally, the first sensor 311 and the second sensor 341 constitute a dual-probe ultrasound sensor 330.

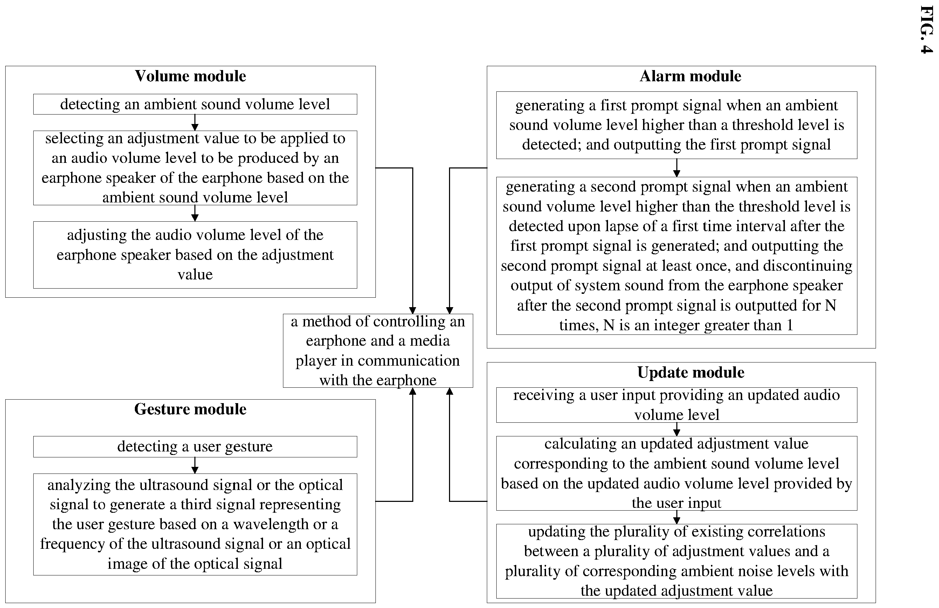

In some embodiments, the apparatus includes a volume module, a gesture module, an update module, and an alarm module (see., e.g., FIG. 4). In some embodiments, the apparatus includes an ambient sound detector configured to detect an ambient sound volume level; a gesture detector configured to detect a user gesture; a processor configured to select an adjustment value to be applied to an audio volume level to be produced by an earphone speaker of the earphone based on the ambient sound volume level, and configured to select a control instruction for controlling a media player in communication with the earphone based on the user gesture; a controller configured to adjust the audio volume level of the earphone speaker based on the adjustment value selected by the processor, and configured to transmit the control instruction to the media player. The processor is configured to generate a first prompt signal when the ambient sound detector detects an ambient sound volume level higher than a threshold level; the controller is configured to receive and output the first prompt signal; the processor is configured to generate a second prompt signal when the ambient sound detector detects an ambient sound volume level higher than the threshold level upon lapse of a first time interval after the first prompt signal is generated; and the controller is configured to output the second prompt signal at least once upon receiving the second prompt signal, and discontinue output of system sound from the earphone speaker after the second prompt signal is outputted for N times, N is an integer greater than 1. Moreover, the processor is configured to receive a user input providing an updated audio volume level, calculate an updated adjustment value corresponding to the ambient sound volume level based on the updated audio volume level provided by the user input, and update the plurality of existing correlations between a plurality of adjustment values and a plurality of corresponding ambient noise levels with the updated adjustment value.

In another aspect, the present disclosure provides an earphone having an apparatus described herein. Optionally, the earphone is a moving coil earphone. Optionally, the earphone is a bone conduction earphone.

In another aspect, the present disclosure provides a media player having an apparatus described herein. Optionally, the media player is a mobile phone or smart phone. Optionally, the media player is a MP3 player.

In another aspect, the present disclosure provides a smart media player system including an earphone and a media player, and an apparatus described herein for controlling the earphone and the media player in communication with the earphone. Optionally, components of the controlling apparatus may be integrated into the earphone. Optionally, components of the controlling apparatus may be integrated into the media player. Optionally, a first portion of the apparatus is integrated into the earphone, and a second portion of the apparatus is integrated into the media player. Optionally, the gesture detector is integrated as a part of the earphone, and the ambient sound detector is integrated as a part of the media player. Optionally, the controlling apparatus is a stand-alone apparatus such as a remote control. Optionally, the smart media player system includes an earphone; a media player; an ambient sound detector configured to detect an ambient sound volume level; a gesture detector configured to detect a user gesture; a processor configured to select an adjustment value to be applied to an audio volume level to be produced by an earphone speaker of the earphone based on the ambient sound volume level, and select a control instruction for controlling a media player in communication with the earphone based on the user gesture; and a controller configured to adjust the audio volume level of the earphone speaker based on the adjustment value selected by the processor, and transmit the control instruction to the media player. Optionally, the sensors of the ambient sound detector and the gesture detector are integrated as a dual-sensor.

In another aspect, the present disclosure provides a smart wearable apparatus having an apparatus described herein for controlling an earphone and a media player in communication with the earphone. Optionally, the earphone is a component of the smart wearable apparatus. Optionally, the earphone is detachably connected to the smart wearable apparatus. Optionally, the smart wearable apparatus and the earphone are separated from each other. In some embodiments, the smart wearable apparatus includes an ambient sound detector configured to detect an ambient sound volume level; a gesture detector configured to detect a user gesture; a processor configured to select an adjustment value to be applied to an audio volume level to be produced by an earphone speaker of the earphone based on the ambient sound volume level, and select a control instruction for controlling a media player in communication with the earphone based on the user gesture; and a controller configured to adjust the audio volume level of the earphone speaker based on the adjustment value selected by the processor, and transmit the control instruction to the media player. Optionally, the sensors of the ambient sound detector and the gesture detector are integrated as a dual-sensor. Examples of wearable apparatuses include, but are not limited to, a smart watch, an electronic ring, an electronic necklace, an electronic bracelet, an electronic badge, an electronic fitness monitoring device, a smart wristband, an electronic hat, smart glasses, a wearable apparatus that is worn on clothing, a wearable apparatus that when worn contacts human skin. Optionally, the wearable apparatus is a smart watch. Optionally, the wearable apparatus is a smart bracelet.

In another aspect, the present disclosure provides a method of controlling an earphone, an disclosed embodiment which is not according to the invention and is present for illustration purposes only. In some embodiments, the method includes detecting an ambient sound volume level; selecting an adjustment value to be applied to an audio volume level to be produced by an earphone speaker of the earphone based on the ambient sound volume level; and adjusting the audio volume level of the earphone speaker based on the adjustment value. Optionally, the method further includes generating a first prompt signal when an ambient sound volume level higher than a threshold level is detected; and outputting the first prompt signal. Optionally, the method further includes generating a second prompt signal when an ambient sound volume level higher than the threshold level is detected upon lapse of a first time interval after the first prompt signal is generated; and outputting the second prompt signal at least once, and discontinuing output of system sound from the earphone speaker after the second prompt signal is outputted for N times, N is an integer greater than 1.

In some embodiments, the step of detecting the ambient sound volume level includes converting the ambient sound volume level to a first signal, and analyzing the first signal to generate a second signal representing the ambient sound volume level. Optionally, the first signal is one of a voltage signal, a current signal, and a pressure signal.

In some embodiments, the step of converting the ambient sound volume level includes converting the ambient sound volume level using a sound sensor. Examples of sound sensors include various microphones, e.g., an electret condenser microphone. In an electret condenser microphone, a sound wave received by the microphone causes vibration of an electret film in the microphone, leading to a capacitance change. A voltage signal or a current signal is generated upon the capacitance change. The first analyzer receives and analyze the voltage signal or the current signal, and generates a second signal representing the ambient sound volume level. In some embodiments, the first sensor is a pressure sensor. The pressure sensor receives a sound wave and generates a pressure signal. Based on the pressure signal, the first analyzer generates a second signal representing the ambient sound volume level.

In some embodiments, the step of selecting the adjustment value to be applied to an audio volume level to be produced by an earphone speaker of the earphone is based on the ambient sound volume level detected, and a plurality of correlations between a plurality of adjustment values and a plurality of corresponding ambient noise levels. The adjustment value is selected based on its correlation to the ambient noise level. Each ambient noise level corresponds to an adjustment value, which in turn corresponds to an audio volume level. The adjustment value may be an increment be added to the existing audio volume level, or a decrement to be subtracted from the existing audio volume level, or a multiplication factor to be applied to the existing audio volume level.

In some embodiments, the correlation between the adjustment values and the ambient noise levels is stored in a look-up table including a plurality of ambient sound volume ranges and a plurality of corresponding adjustment values, each of the ambient sound volume range corresponding to one of the plurality of adjustment values. When a certain ambient sound volume level is detected, the ambient sound volume range including the detected ambient sound volume level can be determined, and the corresponding adjustment value can be conveniently selected using the look-up table. Optionally, the plurality of ambient sound volume ranges are mutually exclusive. Accordingly, in some embodiments, the step of selecting an adjustment value to be applied to an audio volume level to be produced by an earphone speaker of the earphone includes determining an ambient sound volume range encompassing a value corresponding to the detected ambient sound volume level, and selecting an adjustment value corresponding to the ambient sound volume range as the adjustment value to be applied to an audio volume level to be produced by an earphone speaker of the earphone.

In some embodiments, the loop-up table may be automatically updated by user inputs. For example, the method automatically selects an adjustment value to be applied to an audio volume level based on the ambient sound volume level detected, and an existing look-up table including a plurality of existing correlations between a plurality of adjustment values and a plurality of corresponding ambient noise levels; and adjusts the audio volume level of the earphone speaker based on the adjustment value. If the user feels comfortable with the automatically adjusted audio volume level, the user may continue listening to the sound track broadcasted in the earphone. In some embodiments, the method allows a user to manually adjust the audio volume level to a different level for better user experience. The method automatically updates the loop-up table using an updated adjustment value corresponding to the audio volume level selected by the user. By having the design, the control of the earphone may be personalized, and the adjustment can be tailored to each individual. Accordingly, subsequent to the step of selecting an adjustment value to be applied to an audio volume level and the step of adjusting the audio volume level of the earphone speaker based on the adjustment value, in some embodiments, the method further includes receiving a user input providing an updated audio volume level, calculating an updated adjustment value corresponding to the ambient sound volume level based on the updated audio volume level provided by the user input, and updating the plurality of existing correlations between a plurality of adjustment values and a plurality of corresponding ambient noise levels with the updated adjustment value.

In some embodiments, the loop-up table may be automatically updated by user inputs inputted by a user gesture. For example, the method automatically selects an adjustment value to be applied to an audio volume level based on the ambient sound volume level detected, and an existing look-up table including a plurality of existing correlations between a plurality of adjustment values and a plurality of corresponding ambient noise levels; and adjusts the audio volume level of the earphone speaker based on the adjustment value. The user can adjust the audio volume level to a different level using a user gesture. The user gestures include a first user gesture for increasing the audio volume level and a second user gesture for decreasing the audio volume level. The method automatically updates the loop-up table using an updated adjustment value corresponding to the audio volume level adjusted by the user. Accordingly, subsequent to the step of selecting an adjustment value to be applied to an audio volume level and the step of adjusting the audio volume level of the earphone speaker based on the adjustment value, in some embodiments, the method further includes detecting a user gesture providing an updated audio volume level, calculating an updated adjustment value corresponding to the ambient sound volume level based on the updated audio volume level provided by the user gesture, and updating the plurality of existing correlations between a plurality of adjustment values and a plurality of corresponding ambient noise levels with the updated adjustment value.

In the same vein, the user experience may be further enhanced by applying the method described herein to each individual earphone speaker (e.g., a left earbud and a right earbud). Accordingly, in some embodiments, the method includes detecting an ambient sound volume level; selecting a first adjustment value to be applied to an audio volume level to be produced by a first earphone speaker of the earphone based on the ambient sound volume level; selecting a second adjustment value to be applied to an audio volume level to be produced by a second earphone speaker of the earphone based on the ambient sound volume level; adjusting the audio volume level of the first earphone speaker based on the first adjustment value; and adjusting the audio volume level of the second earphone speaker based on the second adjustment value. In some embodiments, the step of selecting the first adjustment value is performed based on the ambient sound volume level detected, and a plurality of first existing correlations between a plurality of adjustment values and a plurality of corresponding ambient noise levels; and the step of selecting the second adjustment value is performed based on the ambient sound volume level detected, and a plurality of second existing correlations between a plurality of adjustment values and a plurality of corresponding ambient noise levels. In some embodiments, the method further includes receiving a first user input providing a first updated audio volume level to be produced by the first earphone speaker, calculating a first updated adjustment value corresponding to the ambient sound volume level, and updating the plurality of first existing correlations with the first updated adjustment value. In some embodiments, the method further includes receiving a second user input providing a second updated audio volume level to be produced by the second earphone speaker, calculating a second updated adjustment value corresponding to the ambient sound volume level, and updating the plurality of second existing correlations with the second updated adjustment value.

In some embodiments, the method includes selecting and applying a first adjustment value to the audio volume level when the ambient sound volume level is in a first ambient sound volume range, and selecting and applying a second adjustment value to the audio volume level when the ambient sound volume level is in a second ambient sound volume range. A minimum ambient sound volume level in the second ambient sound volume range is higher than a maximum ambient sound volume level in the first ambient sound volume range. The second adjustment value is higher than the first adjustment value. Optionally, the look-up table includes the first adjustment value, the second adjustment value, and at least a third adjustment value. Optionally, the look-up table includes the first ambient sound volume range, the second ambient sound volume range, and at least a third ambient sound volume range.

In some embodiments, the step of detecting the ambient sound volume level includes determining a cumulative ambient sound level, for example, ambient sound levels cumulated during a time interval (e.g., 5 seconds, 10 seconds). The ambient sound volume range is a range of cumulative ambient sound levels during a same time interval. Depending on the user needs, an appropriate time interval may be selected.

In some embodiments, the step of detecting the ambient sound volume level includes determining an average ambient sound level over a time period (e.g., 5 seconds, 10 seconds). The ambient sound volume range is a range of average ambient sound levels over a same time period. Depending on the user needs, an appropriate time period may be selected.

Optionally, the correlation between the plurality of adjustment values and the plurality of ambient sound volume ranges is substantially a linear correlation. Optionally, the plurality of audio volume levels adjusted by the plurality of adjustment values and the plurality of ambient sound volume ranges is substantially a linear correlation.

In some embodiment, the method further includes generating and applying an additional adjustment value in lieu of or in addition to the adjustment value applied to the audio volume level. In some examples, the additional adjustment value is an adjustment value for noise cancellation, noise reduction, or noise decreasing. In another example, the method includes calculating a reversed version of the ambient noise, and applying it to cancel out the noise.

In some embodiment, the method further includes generating a prompt signal (e.g., an alarm) when the ambient sound volume level is higher than a threshold value. In one example, the method includes generating a first prompt signal when the ambient sound volume level is higher than a maximum ambient sound volume level in the second ambient sound volume range, and outputting the first prompt signal, e.g., to a user. The prompt signal reminds the user that the ambient noise is at a level not suitable for listening to a sound track using an earphone. Upon receiving the prompt signal, the user may choose to discontinue the media player, or choose to leave the noisy environment. The prompt signal may be a voice message or an alarm sound.

In some embodiments, the method further includes monitoring the ambient noise continuously. For example, the method may include detecting a cumulative ambient sound volume level upon lapse of a time interval, e.g., every 30 seconds. Optionally, the method includes detecting the ambient sound volume level upon lapse of a first time interval (e.g., 30 seconds) after the first prompt signal is generated, selecting an adjustment value to be applied to the audio volume level to be produced by an earphone speaker based on the ambient sound volume level, and adjusting the audio volume level of the earphone speaker based on the selected adjustment value. By repeating the ambient sound detection process, it can be determined whether the ambient sound volume level becomes lower than the threshold value after the first prompt signal is generated.

In some embodiments, it is determined that the ambient sound volume level upon lapse of the first time interval after the first prompt signal is generated is still higher than a maximum ambient sound volume level in the second ambient sound volume range. In some examples, the method further includes generating a second prompt signal, and outputting the second prompt signal, e.g., to the user. Optionally, the method includes outputting the second prompt signal to the user at least once after the second prompt signal is generated. Optionally, the method further includes discontinuing output of system sound from the earphone speaker after outputting the second prompt signal for N times, N is an integer greater than 1, e.g., N = 3. In one example, the second prompt signal is outputted for N times in a certain period of time (e.g., 5 minutes or 10 minutes) before the output of system sound is discontinued.

In some embodiments, the method further includes automatically resuming output of system sound from the earphone speaker upon lapse of a second time interval after output of system sound is discontinued. Optionally, the method further includes repeating the ambient noise detection process and alarm process as described above once the output of system sound is resumed. In one example, the second time interval is 10 minutes.

In some embodiments, the method further includes detecting a user gesture. Optionally, the method includes selecting a control instruction for controlling a media player in communication with the earphone based on the user gesture, and transmitting the control instruction to the media player. Accordingly, the present method enables control the contents broadcasted by the media player using user gesture.

In some embodiments, the step of detecting the user gesture includes detecting an ultrasound signal in response to a user gesture, analyzing the ultrasound signal to generate a third signal representing the user gesture based on a wavelength or a frequency of the ultrasound signal. Based on the third signal, the method further includes selecting a control instruction for controlling a media player in communication with the earphone, and transmitting the control instruction to the media player. Optionally, detecting the ultrasound signal includes detecting the ultrasound signal using an ultrasound sensor.

In some embodiments, the step of detecting the user gesture includes detecting an optical signal in response to a user gesture, analyzing the optical signal to generate a third signal representing the user gesture based on an optical image of the optical signal. Based on the third signal, the method further includes selecting a control instruction for controlling a media player in communication with the earphone, and transmitting the control instruction to the media player. Optionally, detecting the optical signal includes detecting the optical signal using an optical sensor.

In some embodiments, the step of analyzing the ultrasound signal to generate a third signal representing the user gesture is performed based on a wavelength or a frequency of the ultrasound signal, and a correlation between the user gesture and the wavelength or the frequency of the ultrasound signal. Optionally, the method further includes performing an inference computation based on the wavelength or the frequency of the ultrasound signal and the correlation between the user gesture and the wavelength or the frequency of the ultrasound signal, and determining the user gesture corresponding to the ultrasound signal.

In some embodiments, the step of analyzing the optical signal to generate a third signal representing the user gesture is performed based on an optical image of the optical signal, and a correlation between the user gesture and the optical image of the optical signal. Optionally, the method further includes performing an inference computation based on the optical signal and the correlation between the user gesture and the optical image of the optical signal, to determine the user gesture corresponding to the optical signal.

In some embodiments, the method further includes performing a de-noising process on the ultrasound signal. In one example, the method includes receiving the ultrasound signal, performing a de-noising process on the optical signal, and outputting an denoised signal. Optionally, the method further includes analyzing the denoised signal to generate a third signal representing the user gesture, selecting a control instruction for controlling a media player in communication with the earphone bases on the third signal, and transmitting the control instruction to the media player.

In some embodiments, the method further includes performing a de-noising process on the optical signal. In one example, the method includes receiving the optical signal, performing a de-noising process on the optical signal, and outputting an denoised signal. Optionally, the method further includes analyzing the denoised signal to generate a third signal representing the user gesture, selecting a control instruction for controlling a media player in communication with the earphone bases on the third signal, and transmitting the control instruction to the media player.

In some embodiments, the plurality of user gestures include at least one of a first user gesture including a translational motion with a substantially uniform speed; a second user gesture including a translational motion with acceleration; a third user gesture including an up-and-down motion; a fourth user gesture including a clockwise circular motion; a fifth user gesture including a counter-clockwise circular motion; a sixth user gesture including a forward motion; and a seventh user gesture including a backward motion. In some embodiments, the plurality of control instructions include at least one of a first control instruction including pausing the media player; a second control instruction including playing the media player; a third control instruction including changing sound tracks; a fourth control instruction including playing a next track; a fifth control instruction including playing a previous track; a sixth control instruction including playing tracks in a sequential play mode; a seventh control instruction including playing tracks in a shuffle play mode, an eighth control instruction including accepting an incoming phone call; and a ninth control instruction including terminating a phone call. Any of the plurality of control instructions may be paired with one of the plurality of user gestures in the look-up table.

In some embodiments, the method includes detecting an ultrasound sensor; and the plurality of user gestures include a first user gesture including a translational motion with a substantially uniform speed and a second user gesture including a translational motion with acceleration. Optionally, the plurality of control instructions include a first control instruction including pausing the media player; a second control instruction including playing the media player; and a third control instruction including changing sound tracks. In one example, the first user gesture corresponds to a user instruction to pause or play the media player. In another example, the second user gesture corresponds to a user instruction to change sound tracks.

In some embodiments, the method includes detecting an optical sensor; and the plurality of user gestures include a third user gesture including an up-and-down motion; a fourth user gesture including a clockwise circular motion; a fifth user gesture including a counter-clockwise circular motion; a sixth user gesture including a forward motion; and a seventh user gesture including a backward motion. Optionally, the plurality of control instructions include a fourth control instruction including playing a next track; a fifth control instruction including playing a previous track; a sixth control instruction including playing tracks in a sequential play mode; and a seventh control instruction including playing tracks in a shuffle play mode. In one example, the third user gesture corresponds to the fourth control instruction or the fifth control instruction. In another example, the fourth user gesture and the fifth user gesture correspond to the sixth control instruction and the seventh control instruction.

FIG. 4 is a flow chart illustrating a method for controlling an earphone and a media player in communication with the earphone in some embodiments, which is not according to the claimed invention and is present for illustration purposes only. Referring to FIG. 4, the method includes four modules: a volume module, a gesture module, an update module, and an alarm module. In the volume module, the method includes detecting an ambient sound volume level; selecting an adjustment value to be applied to an audio volume level to be produced by an earphone speaker of the earphone based on the ambient sound volume level; and adjusting the audio volume level of the earphone speaker based on the adjustment value. In the gesture module, the method includes detecting a user gesture; selecting a control instruction for controlling the media player in communication with the earphone based on the user gesture; and transmitting the control instruction to the media player. In the alarm module, the method includes generating a first prompt signal when an ambient sound volume level higher than a threshold level is detected; and outputting the first prompt signal; and generating a second prompt signal when an ambient sound volume level higher than the threshold level is detected upon lapse of a first time interval after the first prompt signal is generated; and outputting the second prompt signal at least once, and discontinuing output of system sound from the earphone speaker after the second prompt signal is outputted for N times, N is an integer greater than 1. In the update module, the method includes receiving a user input providing an updated audio volume level, calculating an updated adjustment value corresponding to the ambient sound volume level based on the updated audio volume level provided by the user input, and updating the plurality of existing correlations between a plurality of adjustment values and a plurality of corresponding ambient noise levels with the updated adjustment value.

## Claims

1. An apparatus for controlling an earphone and a media player in communication with the earphone, comprising:
an ambient sound detector (101, 201) configured to detect an ambient sound volume level;
a processor (102, 202) configured to select an adjustment value to be applied to an audio volume level to be produced by an earphone speaker of the earphone based on the ambient sound volume level; and
a controller (103, 203) configured to adjust the audio volume level of the earphone speaker based on the adjustment value selected by the processor (102, 202);
wherein the processor (102, 202) is configured to generate a first prompt signal when the ambient sound detector (101, 201) detects an ambient sound volume level higher than a threshold level; and
the controller (103, 203) is configured to receive and output the first prompt signal,
wherein the processor (102, 202) is configured to generate a second prompt signal when the ambient sound detector (101, 201) detects an ambient sound volume level higher than the threshold level upon lapse of a first time interval after the first prompt signal is generated; and
the controller (103, 203) is configured to output the second prompt signal at least once upon receiving the second prompt signal, and discontinue output of system sound from the earphone speaker after the second prompt signal is output for N times, N is an integer greater than 1.

2. The apparatus of claim 1, wherein the ambient sound detector (201) comprises a first sensor (211) connected to a first analyzer (212);
the first sensor (211) is configured to convert the ambient sound volume level to a first signal; the first signal being one of a voltage signal, a current signal, and a pressure signal; and
the first analyzer (212) is configured to receive and analyze the first signal to generate a second signal representing the ambient sound volume level.

3. The apparatus of claim 2, wherein the first sensor (211) is a sound sensor comprising an electret condenser microphone, or the first sensor (211) is a pressure sensor.

4. The apparatus of claim 1, wherein a first adjustment value is selected and applied to the audio volume level when the ambient sound volume level is in a first ambient sound volume range, and a second adjustment value is selected and applied to the audio volume level when the ambient sound volume level is in a second ambient sound volume range;
a minimum ambient sound volume level in the second ambient sound volume range is higher than a maximum ambient sound volume level in the first ambient sound volume range; and
the second adjustment value is higher than the first adjustment value.

5. The apparatus of claim 4, wherein the processor (102, 202) is configured to generate the first prompt signal when the ambient sound volume level is higher than a maximum ambient sound volume level in the second ambient sound volume range; and
the controller (103, 203) is configured to receive and output the first prompt signal.

6. The apparatus of claim 5, wherein the ambient sound detector (101, 201) is configured to detect the ambient sound volume level upon lapse of the first time interval after the first prompt signal is generated;
the processor (102, 202) is configured to select the adjustment value to be applied to the audio volume level to be produced by an earphone speaker based on the ambient sound volume level; and
the controller (103, 203) is configured to adjust the audio volume level of the earphone speaker based on the adjustment value selected by the processor (102, 202).

7. The apparatus of claim 6, wherein the controller (103, 203) is configured to resume output of system sound from the earphone speaker upon lapse of a second time interval after output of system sound is discontinued.

8. The apparatus of claim 1, further comprising a gesture detector (204) configured to detect a user gesture;
wherein the processor (102, 202) is configured to select a control instruction for controlling a media player in communication with the earphone based on the user gesture; and
the controller (103, 203) is configured to transmit the control instruction to the media player.

9. An earphone, comprising an apparatus of any one of claims 1 to 8.

10. The earphone of claim 9, wherein the earphone is one of a moving coil earphone and a bone conduction earphone.

11. A wearable apparatus, comprising an apparatus of any one of claims 1 to 8.

## Patentansprüche

1. Vorrichtung zur Steuerung eines Ohrhörers und eines mit dem Ohrhörer kommunizierenden Medienspielers, aufweisend:
einen Umgebungsschalldetektor (101, 201), der konfiguriert ist, um einen Umgebungslautstärkepegel zu erfassen;
einen Prozessor (102, 202), der konfiguriert ist, um einen Einstellwert auszuwählen, der auf der Grundlage des Umgebungslautstärkepegels auf einen Audiolautstärkepegel anzuwenden ist, der von einem Ohrhörerlautsprecher des Ohrhörers zu erzeugen ist; und
eine Steuereinheit (103, 203), die konfiguriert ist, um den Audiolautstärkepegel des Ohrhörerlautsprechers auf der Grundlage des Einstellwertes einzustellen, der von dem Prozessor (102, 202) ausgewählt ist;
wobei der Prozessor (102, 202) konfiguriert ist, um ein erstes Aufforderungssignal zu erzeugen, wenn der Umgebungsschalldetektor (101, 201) einen Umgebungslautstärkepegel erfasst, der höher als ein Schwellenpegel ist; und
die Steuereinheit (103, 203) konfiguriert ist, um das erste Aufforderungssignal zu empfangen und auszugeben,
wobei der Prozessor (102, 202) konfiguriert ist, um ein zweites Aufforderungssignal zu erzeugen, wenn der Umgebungsschalldetektor (101, 201) nach Ablauf eines ersten Zeitintervalls, nachdem das erste Aufforderungssignal erzeugt wurde, einen Umgebungslautstärkepegel erfasst, der höher als der Schwellenpegel ist; und
die Steuereinheit (103, 203) konfiguriert ist, um das zweite Aufforderungssignal bei Empfang des zweiten Aufforderungssignals mindestens einmal auszugeben und die Ausgabe von Systemton aus dem Ohrhörerlautsprecher zu unterbrechen, nachdem das zweite Aufforderungssignal N-mal ausgegeben wurde, wobei N eine ganze Zahl größer als 1 ist.

2. Vorrichtung nach Anspruch 1, wobei der Umgebungsschalldetektor (201) einen ersten Sensor (211) aufweist, der mit einem ersten Analysator (212) verbunden ist;
der erste Sensor (211) konfiguriert ist, um den Umgebungslautstärkepegel in ein erstes Signal umzuwandeln, wobei das erste Signal eines von einem Spannungssignal, einem Stromsignal oder einem Drucksignal ist; und
der erste Analysator (212) konfiguriert ist, um das erste Signal zu empfangen und zu analysieren, um ein zweites Signal zu erzeugen, das den Umgebungslautstärkepegel darstellt.

3. Vorrichtung nach Anspruch 2, wobei der erste Sensor (211) ein Schallsensor ist, der ein Elektretkondensatormikrofon aufweist, oder der erste Sensor (211) ein Drucksensor ist.

4. Vorrichtung nach Anspruch 1, wobei ein erster Einstellwert ausgewählt und auf den Audiolautstärkepegel angewendet wird, wenn der Umgebungslautstärkepegel in einem ersten Umgebungslautstärkebereich liegt, und ein zweiter Einstellwert ausgewählt und auf den Audiolautstärkepegel angewendet wird, wenn der Umgebungslautstärkepegel in einem zweiten Umgebungslautstärkebereich liegt;
ein minimaler Umgebungslautstärkepegel in dem zweiten Umgebungslautstärkebereich höher ist als ein maximaler Umgebungslautstärkepegel in dem ersten Umgebungslautstärkebereich; und
der zweite Einstellwert höher ist als der erste Einstellwert.

5. Vorrichtung nach Anspruch 4, wobei der Prozessor (102, 202) konfiguriert ist, um das erste Aufforderungssignal zu erzeugen, wenn der Umgebungslautstärkepegel höher ist als ein maximaler Umgebungslautstärkepegel in dem zweiten Umgebungslautstärkebereich; und
die Steuereinheit (103, 203) konfiguriert ist, um das erste Aufforderungssignal zu empfangen und auszugeben.

6. Vorrichtung nach Anspruch 5, wobei der Umgebungsschalldetektor (101, 201) konfiguriert ist, um den Umgebungslautstärkepegel nach Ablauf des ersten Zeitintervalls, nachdem das erste Aufforderungssignal erzeugt wurde, zu erfassen;
der Prozessor (102, 202) konfiguriert ist, um auf der Grundlage des Umgebungslautstärkepegels den Einstellwert auszuwählen, der auf den Audiolautstärkepegel anzuwenden ist, der von einem Ohrhörerlautsprecher zu erzeugen ist; und
die Steuereinheit (103, 203) konfiguriert ist, um den Audiolautstärkepegel des Ohrhörerlautsprechers auf der Grundlage des Einstellwertes, der von dem Prozessor (102, 202) ausgewählt ist, einzustellen.

7. Vorrichtung nach Anspruch 6, wobei die Steuereinheit (103, 203) konfiguriert ist, um eine Ausgabe von Systemton aus dem Ohrhörerlautsprecher nach Ablauf eines zweiten Zeitintervalls, nachdem die Ausgabe von Systemton unterbrochen wurde, wieder aufzunehmen.

8. Vorrichtung nach Anspruch 1, ferner einen Gestendetektor (204) aufweisend, der konfiguriert ist, um eine Benutzergeste zu erfassen;
wobei der Prozessor (102, 202) konfiguriert ist, um eine Steueranweisung zum Steuern eines mit dem Ohrhörer kommunizierenden Medienspielers auf der Grundlage der Benutzergeste auszuwählen; und
die Steuereinheit (103, 203) konfiguriert ist, um die Steueranweisung an den Medienspieler zu übertragen.

9. Ohrhörer, eine Vorrichtung nach einem der Ansprüche 1 bis 8 aufweisend.

10. Ohrhörer nach Anspruch 9, wobei der Ohrhörer eines von einem Ohrhörer mit beweglicher Spule oder einem Knochenleitungsohrhörer ist.

11. Tragbare Vorrichtung, eine Vorrichtung nach einem der Ansprüche 1 bis 8 aufweisend.

## Revendications

1. Un appareil pour commander un écouteur et un lecteur multimédia en communication avec l'écouteur, comprenant :
un détecteur de son ambiant (101, 201) configuré pour détecter un niveau de volume sonore ambiant ;
un processeur (102, 202) configuré pour sélectionner une valeur d'ajustement à appliquer à un niveau de volume audio devant être produit par un haut-parleur d'écouteur de l'écouteur sur la base du niveau de volume sonore ambiant ; et
un contrôleur (103, 203) configuré pour ajuster le niveau de volume audio du haut-parleur d'écouteur sur la base de la valeur d'ajustement sélectionnée par le processeur (102, 202) ;
le processeur (102, 202) étant configuré pour générer un premier signal d'invite lorsque le détecteur de son ambiant (101, 201) détecte un niveau de volume sonore ambiant supérieur à un niveau seuil ; et
le contrôleur (103, 203) est configuré pour recevoir et émettre le premier signal d'invite,
le processeur (102, 202) étant configuré pour générer un deuxième signal d'invite lorsque le détecteur de son ambiant (101, 201) détecte un niveau de volume sonore ambiant plus élevé supérieur au niveau seuil après l'écoulement d'un premier intervalle de temps après la génération du premier signal d'invite ; et
le contrôleur (103, 203) est configuré pour émettre le deuxième signal d'invite au moins une fois lors de la réception du deuxième signal d'invite, et interrompre la sortie du son du système depuis le haut-parleur de l'écouteur après que le deuxième signal d'invite ait été émis N fois, N étant un nombre entier supérieur à 1.

2. L'appareil selon la revendication 1, dans lequel le détecteur de son ambiant (201) comprend un premier capteur (211) connecté à un premier analyseur (212) ;
le premier capteur (211) est configuré pour convertir le niveau de volume sonore ambiant en un premier signal ;
le premier signal étant un signal de tension, un signal de courant ou un signal de pression ; et
le premier analyseur (212) est configuré pour recevoir et analyser le premier signal afin de générer un deuxième signal représentant le niveau de volume sonore ambiant.

3. L'appareil selon la revendication 2, dans lequel le premier capteur (211) est un capteur sonore comprenant un microphone à condensateur électret, ou le premier capteur (211) est un capteur de pression.

4. L'appareil selon la revendication 1, dans lequel une première valeur d'ajustement est sélectionnée et appliquée au niveau de volume audio lorsque le niveau de volume sonore ambiant est dans une première plage de volume sonore ambiant, et une deuxième valeur d'ajustement est sélectionnée et appliquée au niveau de volume audio lorsque le niveau de volume sonore ambiant se situe dans une deuxième plage de volume sonore ambiant ;
un niveau de volume sonore ambiant minimum dans la deuxième plage de volumes sonores ambiants est supérieur à un niveau de volume sonore ambiant maximum dans la première plage de volumes sonores ambiants ; et
la deuxième valeur d'ajustement est supérieure à la première valeur d'ajustement.

5. L'appareil selon la revendication 4, dans lequel le processeur (102, 202) est configuré pour générer le premier signal d'invite lorsque le niveau de volume sonore ambiant est supérieur à un niveau de volume sonore ambiant maximum dans la deuxième plage de volume sonore ambiant ; et
le contrôleur (103, 203) est configuré pour recevoir et émettre le premier signal d'invite.

6. L'appareil selon la revendication 5, dans lequel le détecteur de son ambiant (101, 201) est configuré pour détecter le niveau de volume sonore ambiant à l'expiration du premier intervalle de temps après la génération du premier signal d'invite ;
le processeur (102, 202) est configuré pour sélectionner la valeur d'ajustement à appliquer au niveau de volume audio devant être produit par un haut-parleur d'écouteur sur la base du niveau de volume sonore ambiant ; et
le contrôleur (103, 203) est configuré pour ajuster le niveau de volume audio du haut-parleur d'écouteur sur la base de la valeur d'ajustement sélectionnée par le processeur (102, 202).

7. L'appareil selon la revendication 6, dans lequel le contrôleur (103, 203) est configuré pour reprendre la sortie du son du système à partir du haut-parleur des écouteurs après l'écoulement d'un deuxième intervalle de temps après l'arrêt de la sortie du son du système.

8. L'appareil selon la revendication 1, comprenant en outre un détecteur de geste (204) configuré pour détecter un geste d'utilisateur ;
le processeur (102, 202) étant configuré pour sélectionner une instruction de commande pour commander un lecteur multimédia en communication avec l'écouteur sur la base du geste de l'utilisateur ; et
le contrôleur (103, 203) est configuré pour transmettre l'instruction de commande au lecteur multimédia.

9. Un écouteur, comprenant un appareil selon l'une quelconque des revendications 1 à 8.

10. L'écouteur selon la revendication 9, dans lequel l'écouteur est l'un parmi un écouteur à bobine mobile et un écouteur à conduction osseuse.

11. Un appareil portable, comprenant un appareil selon l'une quelconque des revendications 1 à 8.
